Europäisches Patentamt

European Patent Office

Office européen des brevets

(19)

(11) Publication number: **0 112 489**
**A1**

# EUROPEAN PATENT APPLICATION

(12)

(21) Application number: **83111551.4**

(22) Date of filing: **18.11.83**

(51) Int. Cl.³: **H 01 L 21/76, H 01 L 21/74**

(30) Priority: **18.11.82 JP 202290/82**

(43) Date of publication of application: **04.07.84**
**Bulletin 84/27**

(84) Designated Contracting States: **DE FR GB IT**

(71) Applicant: **TOKYO SHIBAURA DENKI KABUSHIKI KAISHA, 72, Horikawa-cho Saiwai-ku, Kawasaki-shi Kanagawa-ken 210 (JP)**

(72) Inventor: **Koshino, Yutaka, 3-10-6, Uragaoka, Yokosuka-shi Kanagawa-ken (JP)**
Inventor: **Yasuda, Seiji, 889 Hiyoshihoncho Kohoku-ku, Yokohama-shi (JP)**
Inventor: **Ajima, Takashi, 2-9-28, Oomachi, Kamakura-shi Kanagawa-ken (JP)**
Inventor: **Yonezawa, Toshio, 6-20-46, Kugo-cho, Yokosuka-shi Kanagawa-ken (JP)**

(74) Representative: **Lehn, Werner, Dipl.-Ing. et al, Hoffmann, Eitle & Partner Patentanwälte Arabellastrasse 4 (Sternhaus), D-8000 München 81 (DE)**

(54) Semiconductor device with compact isolation and method of making the same.

(57) A semiconductor device has a semiconductor substrate (21) of one conductivity type, a buried layer (22) of the opposite conductivity type which is formed on the semiconductor substrate (21), a first semiconductor layer (23) formed on the buried layer (22) and of the same conductivity type as that of the buried layer (22), an electrode leading semiconductor region (26) formed in the first semiconductor layer (23) and of the same conductivity type as the first semiconductor layer (23), a trench (29) extending through the first semiconductor layer (23) and the buried layer (22), reaching the semiconductor substrate (21), and exposing the electrode leading semiconductor region (26), a diffusion layer (30) formed in the side walls of the trench (29) and of the same conductivity type as that of the buried layer (22) for electrically connecting the electrode leading semiconductor region (26) with the buried layer (22), a channel stopper layer (31) formed in the bottom surface of the trench (29) and of the same conductivity type as that of the semiconductor substrate (21); and an insulating material (32) filled in said trench. The invention provides a semiconductor device having a high dielectric withstand voltage and a high packing density at a high yield.

0112489

- 1 -

## Semiconductor device and method for manufacturing the same

The present invention relates to a semiconductor device and a method for manufacturing the same and, more particularly, to a high dielectric withstand voltage type bipolar integrated circuit having a size-reduced element isolation regions and a method for manufacturing the same.

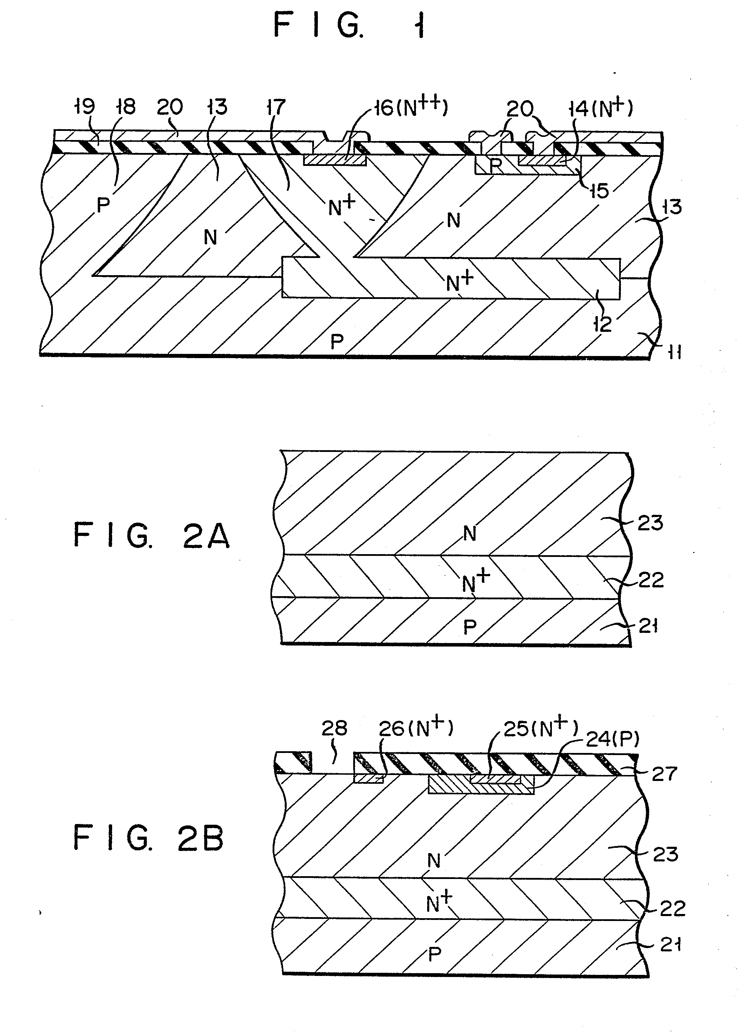

In bipolar integrated circuits having elements with a high power output and a high dielectric withstand voltage, a deep element isolation region is required. Fig. 1 is a sectional view of a conventional semicnductor device having a deep element isolation region.

Referring to Fig. 1, reference numeral 11 denotes a p-type semiconductor substrate; 12, an $n^+$-type buried layer; 13, an n-type epitaxial layer; 14, an $n^+$-type emitter region; 15, a p-type base region; 16, an $n^{++}$-type collector contact region; 17, an $n^+$-type diffusion layer reaching the $n^+$-type buried layer 12; 18, a p-type isolation region isolating elements by a p-n junction; 19, an insulating film; and 20, an electrode wiring layer.

In the semiconductor device having the structure described above, since the $n^+$-type buried layer 12 is deeply buried in the device, the area of the $n^+$-type diffusion layer 17 reaching the $n^+$-type buried layer 12 is increased. Furthermore, the area of the epitaxial layer 13 which is formed between the diffusion layer 17 and the p-type isolation region 18 is increased, thus decreasing the packing density. In addition to these disadvantages, an impurity is diffused at a high temperature for a long period of time to form the diffusion layer 17. Inevitably, the crystal defect tends to occur, and the yield of pellets is decreased.

It is an object of the present invention to provide a semiconductor device having a size-reduced isolation region and a method for manufacturing the same, wherein a dielectric withstand voltage can be increased, and the yield of pellets can be increased.

According to an aspect of the present invention, there is provided a semiconductor device comprising:

a semiconductor substrate of one conductivity type;

a buried layer of an opposite conductivity type which is formed on said semiconductor substrate;

a first semiconductor layer formed on said buried layer and of the same conductivity type as that of said buried layer;

an electrode leading semiconductor region formed in said first semiconductor layer and of the same conductivity type as that of said first semiconductor layer;

a trench extending through said first semiconductor layer and said buried layer, reaching said semiconductor substrate, and exposing said electrode leading semiconductor region;

a second semiconductor layer formed in a side wall of said trench and of the same conductivity type as that of said buried layer for electrically connecting said electrode leading semiconductor region with said buried layer;

a third semiconductor layer formed in a bottom surface of said trench and of the same conductivity type as that of said semiconductor substrate; and

an insulating material filled in said trench.

The above-mentioned trench is formed such that a shallow trench is formed by reactive ion etching to extend through the first semiconductor layer and reach the buried layer, and then the second semiconductor layer is formed in the side wall of the trench and the bottom surface of the trench is further etched by reactive ion etching such that the trench extends through the buried layer and reaches the semiconductor substrate. The first semiconductor layer is preferably an epitaxial layer, and the second semiconductor layer is preferably a diffusion layer. The trench filled with the insulating material constitutes a size-reduced isolation region. The second semiconductor layer having a small size, and reaching the buried layer can be formed within a short period of time.

This invention can be more fully understood from the following detailed description when taken in conjunction with the accompanying drawings, in which:

Fig. 1 is a sectional view of a conventional semiconductor device having a deep element isolation region;

Figs. 2(A) to 2(H) are respectively sectional views showing the steps of manufacturing a semiconductor device according to an embodiment of the present invention; and

Fig. 3 is a sectional view of a semiconductor device according to another embodiment of the present invention.

A semiconductor device according to an embodiment of the present invention will be described with reference to the amnufacturing steps in Figs. 2(A) to 2(H).

As shown in Fig. 2(A), antimony (Sb) is doped in a p-type silicon substrate 21 at a high concentration to form an $n^+$-type buried layer 22. An n-type epitaxial layer 23 is formed by epitaxial growth on the $n^+$-type buried layer 22.

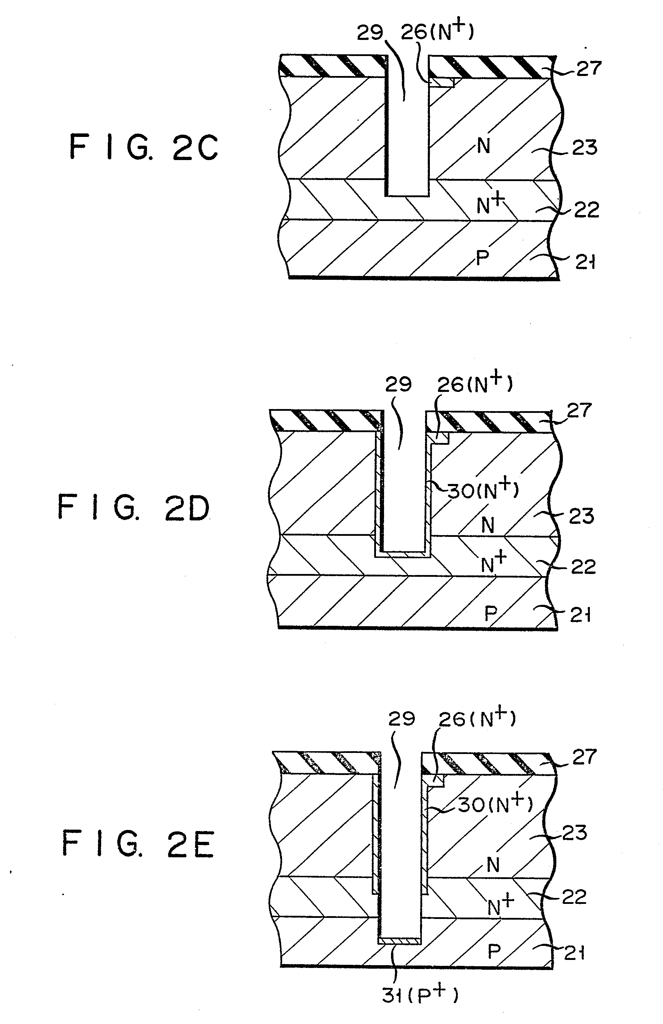

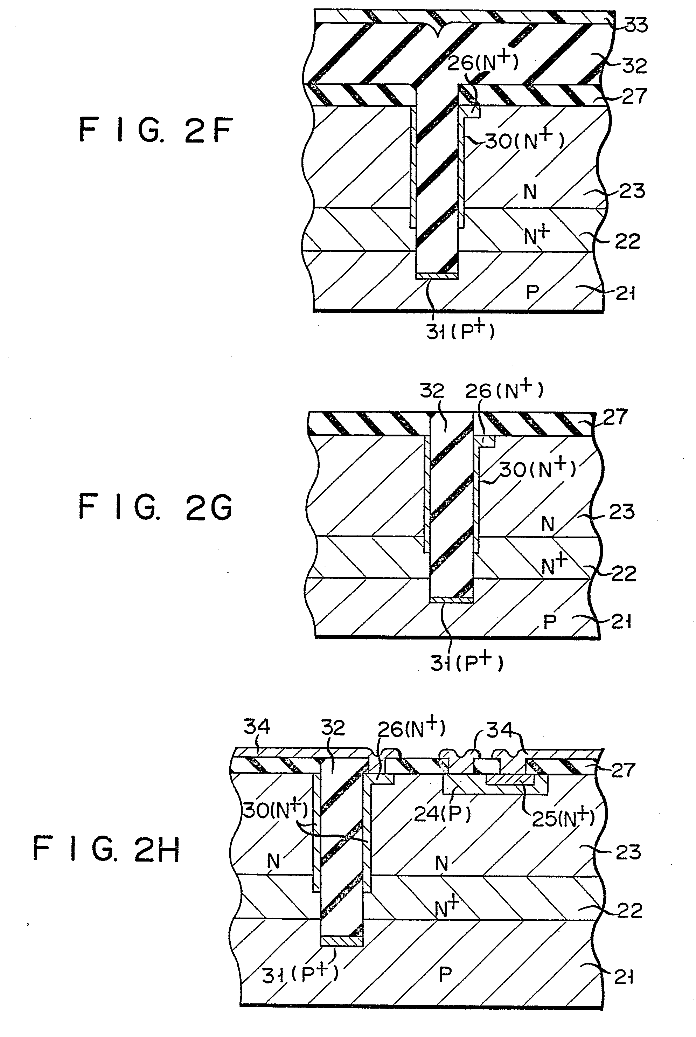

A p-type base region 24, an $n^+$-type emitter region 25 and an $n^+$-type collector contact region 26 of a bipolar transistor are formed in the epitaxial layer 23 in a known manner (Fig. 2(B)). An oxide film 27 is formed on the surface of the epitaxial layer 23 and is selectively etched to form an opening 28. This opening 28 is used to form an isolation region to be described later. By using the oxide film 27 as a mask, RIE (reactive ion etching) is performed to form a trench 29 (depth of about 30 $\mu$m) which extends through the epitaxial layer 23 and reaches the buried layer 22, and which exposes the $n^+$-type collector contact region 26 (Fig. 2(C)). By this etching method, the width of the trench 29 is substantially the same as that of the opening 28. The trench 29 has vertical side walls. Thereafter, impurity diffusion is performed at a temperature of 950°C by using $POCl_3$ (phosphorus oxychloride) as an impurity diffusion source so that an $n^+$-type diffusion layer 30 is formed in the side walls and the bottom surface of the trench 29 to a thickness of 1 $\mu$m (Fig. 2(D)). As a result, the $n^+$-type buried layer 22 is electrically connected to the $n^+$-type collector contact region 26 through the $n^+$-type diffusion layer 30. The bottom surface of the trench 29 is further etched by reactive ion etching so as to extend through the buried layer 22 so that the silicon substrate 21 is exposed. Thereafter, boron is ion-implanted at the bottom of the deep trench to form a $p^+$-type layer 31 serving as a channel stopper (Fig. 2(E)). Subsequently, an insulating material 32 such as $SiO_2$ or $Si_3N_4$ is deposited by plasma CVD or low pressure CVD in the trench 29 (Fig. 2(F)). In this case, a layer of the insulating material 32 is also deposited on the surface of the oxide film 27, so that a recess (valley) is formed in the surface of the insulating material layer which is located above the trench 29. In order to smoothen the recess, an organic material layer 33 such as a photoresist material layer is formed. The layer of insulating material 32 and the organic material layer 33 are etched by sputtering until the surface of the oxide film 27 is exposed (Fig. 2(G)). PEP (photoengraving process) is performed to selectively form electrode contact holes in the oxide film 27, and an electrode metal film is deposited. The electrode metal film is selectively etched by PEP, thereby forming an electrode pattern 34 (Fig. 2(H)). Finally, sintering is performed and PSG (phosphosilicate glass) is applied, thereby preparing desired bipolar integrated circuits.

The above-mentioned integrated circuits include an npn transistor. This transistor has a size-reduced $n^+$-type diffusion layer 30 in the side walls of the trench 29 constituting the isolation region. The $n^+$-type diffusion layer 30 is connected to the $n^+$-type buried layer 22.

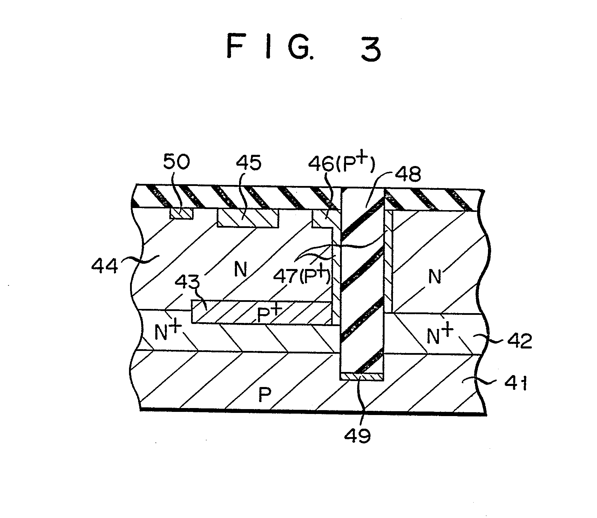

Fig. 3 shows a semiconductor device according to another embodiment of the present invention. The bipolar integrated circuit shown in Fig. 3 includes a pnp vertical transistor. The vertical transistor has a size-reduced $p^+$-type diffusion layer 47 in the side walls of a trench filled with an insulating material. The $p^+$-type layer 47 electrically connects a $p^+$-type collector contact region 46 with a $p^+$-type buried layer 43 which is selectively formed. Referring to Fig. 3, reference numeral 41 denotes a p-type silicon substrate; 42, an $n^+$-type buried layer formed to cover the entire surface of the silicon substrate 41; 44, an n-type epitaxial layer; 45, a p-type emitter region; 49, a $p^+$-type channel stopper; and 50, an $n^+$-type base contact region.

In integrated circuits having the pnp vertical transistor of Fig. 3 and the npn transistor of Fig. 2(H), the $p^+$-type buried layer 43 is selectively performed on the $n^+$-type buried layer 42.

In any one of the two embodiments described above, since the $n^+$-type buried layer is formed to cover the entire surface of the silicon substrate to a great thickness, the $n^+$-type buried layer must be selectively etched by RIE when the trench is formed. The $n^+$-type buried layer is generally 3 - 4 µm deep. Thus it somewhat takes time to remove the $n^+$-type buried layer by RIE. To shorten the etching time of the $n^+$-type buried layer, an $n^+$-type buried layer may be selectively formed on the silicon substrate, a trench may be formed in the portions which said $n^+$-type buried layer is not formed and then the bottom surface of the trench may be etched to expose the silicon substrate.

In the two embodiments described above, active elements such as a transistor are formed before an isolation region is formed within an epitaxial layer. However, the isolation region may be formed first, followed by forming the active elements.

According to the present invention as described above, the area of the isolation region made of the insulating material filled in the deep trench and the area of the diffusion layer which is formed along the side walls of the trench so as to be connected with the buried layer and which has a high impurity concentration whose conductivity type is the same as that of the buried layer can be decreased. Therefore, the area of the pellet of the semiconductor device of the present invention is decreased to 1/3 to 1/4 as compared with the pellet area of the conventional semiconductor device having the same electrical characteristics as those of the semiconductor device of the present invention. Unlike the conventional p-n junction isolation region providing only a dielectric withstand voltage of 200 V, isolation by the isolation region of the present invention can provide at least a dielectric withstand voltage of 700 V or higher. Furthermore, unlike the conventional method in which diffusion is performed at a high temperature for a long period of time, the method of the present invention does not require such diffusion, thereby greatly decreasing the incidence of the crystal defect in the semiconductor crystals. In addition to these advantages, the yield of semiconductor devices of the present invention is 90% or more, while the yield of conventional semiconductor devices is 55 to 60% (average).

Claims:

1.   A semiconductor device comprising:

a semiconductor substrate of one conductivity type;

a buried layer of an opposite conductivity type which is formed on said semiconductor substrate;

a first semiconductor layer formed on said buried layer and of the same conductivity type as that of said buried layer;

an electrode leading semiconductor region formed in said first semiconductor layer and of the same conductivity type as that of said first semiconductor layer;

a trench extending through said first semiconductor layer, reaching said buried layer, and exposing said electrode leading semiconductor region; and

a second semiconductor layer formed in a side wall of said trench and of the same conductivity type as that of said buried layer, for electrically connecting said electrode leading semiconductor region with said buried layer.

2.   A semiconductor device comprising:

a semiconductor substrate of one conductivity type;

a buried layer of an opposite conductivity type which is formed on said semiconductor substrate;

a first semiconductor layer formed on said buried layer and of the same conductivity type as that of said buried layer;

an electrode leading semiconductor region formed in said first semiconductor layer and of the same conductivity type as that of said first semiconductor layer;

a trench extending through said first semiconductor layer and said buried layer, reaching said semiconductor substrate, and exposing said electrode leading semiconductor region;

a second semiconductor layer formed in a side wall of said trench and of the same conductivity type as that of said buried layer for electrically connecting said electrode leading semiconductor region with said buried layer; and

a third semiconductor layer formed in a bottom surface of said trench and of the same conductivity type as that of said semiconductor substrate.

3.  A semiconductor device comprising:

a semiconductor substrate of one conductivity type;

a buried layer of an opposite conductivity type which is formed on said semiconductor substrate;

a first semiconductor layer formed on said buried layer and of the same conductivity type as that of said buried layer;

an electrode leading semiconductor region formed in said first semiconductor layer and of the same conductivity type as that of said first semiconductor layer;

a trench extending through said first semiconductor layer and said buried layer, reaching said semiconductor substrate, and exposing said electrode leading semiconductor region;

a second semiconductor layer formed in a side wall of said trench and of the same conductivity type as that of said buried layer for electrically connecting said electrode leading semiconductor region with said buried layer;

a third semiconductor layer formed in a bottom surface of said trench and of the same conductivity type as that of said semiconductor substrate; and

an insulating material filled in said trench.

4.  A device according to claim 3, wherein said first semiconductor layer comprises an epitaxial layer.

5.  A device according to claim 3, wherein said second semiconductor layer comprises a diffusion layer.

6.  A device according to claim 3, wherein said third semiconductor layer comprises an ion-implantation layer.

7. A device according to claim 6, wherein said ion-implantation layer serves as a channel stopper.

8. A method for manufacturing a semiconductor device, comprising the steps of:

sequentially forming on a semiconductor substrate of one conductivity type a buried layer of an opposite conductivity type to that of said semiconductor substrate and a first semiconductor layer of the same conductivity type as that of said buried layer;

forming an electrode leading semiconductor region of the same conductivity type as that of said first semiconductor layer in said first semiconductor layer;

forming a shallow trench by reactive ion etching, said shallow trench extending through said first semiconductor layer, reaching said buried layer, and exposing said electrode leading semiconductor region; and

forming in a side wall of said shallow trench a second semiconductor layer which electrically connects said electrode leading semiconductor region with said buried layer and which is of the same conductivity type as that of said buried layer.

9. A method for manufacturing a semiconductor device, comprising the steps of:

sequentially forming on a semiconductor substrate of one conductivity type a buried layer of an opposite conductivity type to that of said semiconductor substrate and a first semiconductor layer of the same conductivity type as that of said buried layer;

forming an electrode leading semiconductor region of the same conductivity type as that of said first semiconductor layer in said first semiconductor layer;

forming a shallow trench by reactive ion etching, said shallow trench extending through said first semiconductor layer, reaching said buried layer, and exposing said electrode leading semiconductor region;

forming in a side wall of said shallow trench a second semiconductor layer which electrically connects said electrode leading semiconductor region with said buried layer and which is of the same conductivity type as that of said buried layer;

forming a deep trench by etching a bottom surface of said shallow trench by means of reactive ion etching so that said deep trench extends through said buried layer and reaches said semiconductor substrate; and

forming a third semiconductor layer of the same conductivity as that of said semiconductor substrate in a bottom surface of said deep trench.

10. A method for manufacturing a semiconductor device, comprising the steps of:

sequentially forming on a semiconductor substrate of one conductivity type a buried layer of an opposite conductivity type to that of said semiconductor substrate and a first semiconductor layer of the same conductivity type as that of said buried layer;

forming an electrode leading semiconductor region of the same conductivity type as that of said first semiconductor layer in said first semiconductor layer;

forming a shallow trench by reactive ion etching, said shallow trench extending through said first semiconductor layer, reaching said buried layer, and exposing said electrode leading semiconductor region;

forming in a side wall of said shallow trench a second semiconductor layer which electrically connects said electrode leading semiconductor region with said buried layer and which is of the same conductivity type as that of said buried layer;

forming a deep trench by etching a bottom surface of said shallow trench by means of reactive ion etching so that said deep trench extends through said buried layer and reaches said semiconductor substrate;

forming a third semiconductor layer of the same conductivity as that of said semiconductor substrate in a bottom surface of said deep trench; and

filling an insulating material in said deep trench.

11.    A method according to claim 10, wherein said first semiconductor layer is formed by epitaxial growth.

12.    A method according to claim 10, wherein said second semiconductor is formed by impurity diffusion.

13.    A method according to claim 10, wherein said third semiconductor layer is formed by ion implantation.

FIG. 1

FIG. 2A

FIG. 2B

0112489

**F I G. 2C**

**F I G. 2D**

**F I G. 2E**

**F I G. 2F**

33
32
26(N⁺)
27
30(N⁺)
N — 23
N⁺ — 22
P — 21
31(P⁺)

**F I G. 2G**

32  26(N⁺)
27
30(N⁺)
N — 23
N⁺ — 22
P — 21
31(P⁺)

**F I G. 2H**

34  32  26(N⁺)  34
27
30(N⁺)  24(P)  25(N⁺)
N  N — 23
N⁺ — 22
31(P⁺)  P — 21

# F I G. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X | EP-A-0 004 298 (WESTERN ELECTRIC CO.)<br>* Page 5, line 36 - page 8, line 24 *<br><br>--- | 1-5,8-12 | H 01 L 21/76<br>H 01 L 21/74 |
| A | US-A-4 104 086 (BONDUR et al.)<br>* Column 4, line 52 - column 5, line 6 *<br><br>----- | 8 | |

TECHNICAL FIELDS
SEARCHED (Int. Cl. 3)

H 01 L 21/76

The present search report has been drawn up for all claims

| Place of search<br>BERLIN | Date of completion of the search<br>19-01-1984 | Examiner<br>GIBBS C.S. |
|---|---|---|